## Europäisches Patentamt

(19) **European Patent Office**

**Office européen des brevets**

(11) Veröffentlichungsnummer: **0 203 354**
**B1**

(12) # EUROPÄISCHE PATENTSCHRIFT

(45) Veröffentlichungstag der Patentschrift:
26.09.90

(51) Int. Cl.⁵: **H03K 17/64,** H01F 7/18,
F01L 9/04

(21) Anmeldenummer: 86105475.7

(22) Anmeldetag: 21.04.86

(54) Verfahren und Schaltung zum Betreiben eines Gaswechselventils.

(30) Priorität: 25.04.85 DE 3515039

(43) Veröffentlichungstag der Anmeldung:
03.12.86 Patentblatt 86/49

(45) Bekanntmachung des Hinweises auf die Patenterteilung:
26.09.90 Patentblatt 90/39

(84) Benannte Vertragsstaaten:
DE FR GB IT SE

(56) Entgegenhaltungen:
DE-A- 2 828 678
DE-A- 3 024 109
US-A- 4 511 945

(73) Patentinhaber: **AUDI AG,**
**Auto-Union-Strasse 1 Postfach 220,**
**D-8070 Ingolstadt(DE)**

(72) Erfinder: **Büchl, Josef, Rehsteig 12, D-8071 Lenting(DE)**

**Beschreibung**

Die Erfindung betrifft ein Verfahren zum Betreiben eines Gaswechselventiles einer Brennkraftmaschine.

Aus der DE-A 3 024 109 ist es bekannt, ein Gaswechselventil für eine Brennkraftmaschine vorzusehen, das durch ein Federsystem in seine Öffnungs- und Schließposition gedrückt wird und in den jeweiligen Positionen durch die Erregung eines Elektromagneten gehalten wird.

Die Stromansteuereung, die für den Elektromagneten notwendig ist, bedingt aufgrund der hohen aufzuwendenden Haltekräfte des Magneten einen verhältnismäßig hohen Strom. Dabei ist jedoch insbesondere der Fangstrom verhältnismäßig hoch, während nach dem Einfangen die Gaswechselventile auch mit kleineren Strömen gehalten werden können.

Aus der DE-A 2 828 678 ist für das Einspritzventil einer Brennkraftmaschine bekannt, einen das Einspritzventil betätigenden Elektromagneten mit einer Freilaufschaltung zu versehen, wobei ebenfalls ein hoher Fangstrom und ein kleinerer, getakteter Haltestrom vorgesehen ist. Die dort gezeigte Figur 11 beschreibt eine Ansteuerung für die Freilaufschaltung, in der nach dem Abschalten bei Erreichen einer maximalen Stromstärke während der Haltephase ein Zeitglied anläuft, nach dessen Auslauf ein erneuter Stromstoß für die Haltephase zugeführt wird. Auf diese Weise wird eine Taktung mit festen Abschaltzeiträumen unter Zugrundelegung fester Betriebsparameter erreicht.

Aufgabe der Erfindung ist es, bei einem gattungsgemäßen Ansteuerungsverfahren den Energiebedarf des Elektromagneten unter Berücksichtigung variabler Betriebsparameter abzusenken.

Die Aufgabe wird gelöst durch die im Anspruch angegebenen Mermale.

Erfindungsgemäß ist vorgesehen, daß während der Ausschaltphase der Abfall des Stromes bei ausgeschalteter Versorgungsspannung simuliert wird. Sobald dieser simulierte Strom auf einen unteren Wert gefallen ist, der als unterer Schwellwert gilt, wird die Versorgungsspannung wieder eingeschaltet und dementsprechend der Anstieg gemessen.

Im folgenden wird die Erfindung anhand der Zeichnung erläutert. Es zeigen:

Fig. 1 einen Schaltungsaufbau für das erfindungsgemäße Verfahren, und

Fig. 2 ein Stromflußdiagramm zur Erläuterung der Erfindung.

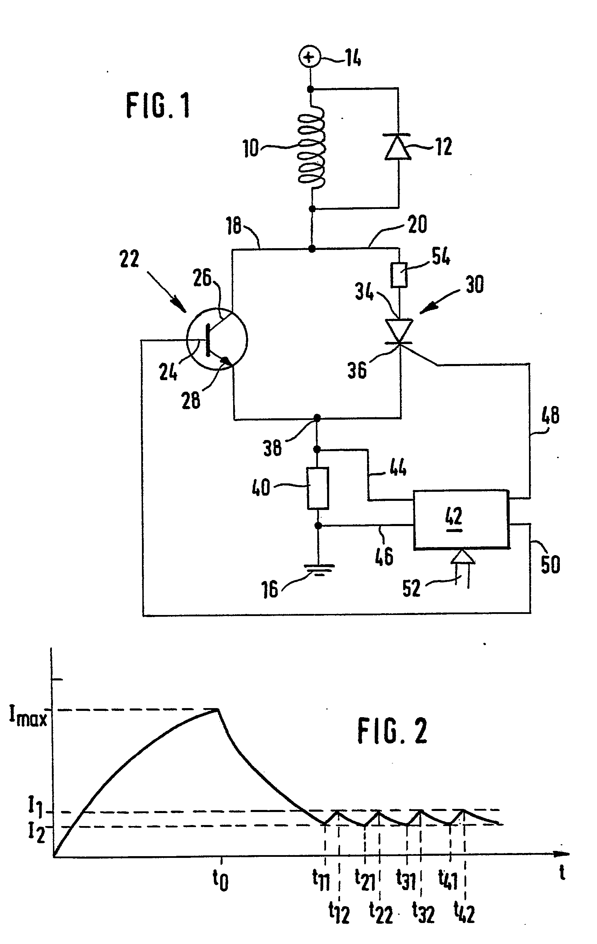

In Fig. 1 ist der Aufbau der Schaltung, die nach dem erfindungsgemäßen Verfahren arbeitet, gezeigt.

Die Gaswechselventile, die nicht dargestellt sind, werden über einen Elektromagneten 10 in ihren Öffnungs- bzw. Schließpositionen gehalten, dem Elektromagneten 10 ist ein Freilauf 12 zugeordnet, der hier als einfachster Fall in Form einer Diode 12 dargestellt ist. Die positive Versorgungsspannung ist mit 14 bezeichnet, der Masseanschluß für die Schaltung mit 16. Die Parallelschaltung von Elektrospule 10 und Diode 12, deren Kathode am positiven Anschluß und deren Anode am negativen Anschluß liegt, ist verbunden mit einer Schaltung, die sich in zwei Zweige 18 und 20 aufteilt. Der Zweig 18 verbindet den der positiven Spannung 14 abgewandten Seite der Spule 10 über die Kollektor-Emitter-Strecke eines Transistors 22 über einen Shunt 40 mit dem Masseanschluß 16, der Zweig 20 liegt dazu parallel und verbindet den nämlichen Anschluß der Spule 10 über einen Thyristor 30 und den Shunt 40 mit dem Masseanschluß 16.

Der Kollektor 26 des Transistors 22 ist mit der Spule verbunden, der Emitter 28 führt über den Shunt 40 zum Masseanschluß 16. Die Verbindung der beiden Zweige im Punkt 38 kurz vor dem Masseanschluß 16 ist über den Shunt, einen ohmschen Widerstand 40, auf Masse 16 gelegt, auf den noch im späteren Verlauf einzugehen sein wird.

Im Zweig 20 ist der Thyristor 30 mit seiner Anode 34 der Spule zugewandt, die Kathode 32 führt zum Zusammenführungspunkt 38, in dem die Zweige 18 und 20 wieder zusammenlaufen. Das Gate 36 des Thyristors 30 wird von einem Ausgang 48 eines Steuergliedes 42 angesteuert, der zweite Ausgang 50 des Steuergliedes 42 führt auf die Basis 24 des Transistors 22.

Die beiden Eingänge 44 und 46 des Steuergliedes 42 greifen die Spannung über dem ohmschen Widerstand 40 ab. Weiterhin erhält das Steuerglied 42, wie mit der angedeuteten Busleitung 52 dargestellt, Informationen, die die Ansteuerung von Transistor 22 und Thyristor 30 abhängig von anderen Motorparametern erlaubt.

Die Funktion der Erfindung soll im folgenden anhand des in Fig. 2 dargestellten Stromverlaufs durch die Spule 10 erläutert werden.

Wenn die Gaswechselventile, wie in der DE-OS 3 024 109 offenbart, in ihrer Öffnungs- bzw. Schließposition durch den Elektromagneten 10 gehalten werden sollen, ist zum Einfangen der Gaswechselventile ein verhältnismäßig hoher Fangstrom notwendig. Dementsprechend steigt durch Einschalten der Spannung der Strom auf einen Wert $I_{max}$, in dem über das Steuerglied 42 am Ausgang 48 ein Impuls an das Gate 36 des Thyristors 30 geführt wird, wodurch der Thyristor zündet und der Einschaltstrom ansteigt. Der Anstieg des Stromes, also der aktuelle Stromwert, kann durch das Steuergerät 42 ermittelt werden, indem der Spannungsabfall über dem ohmschen Widerstand 40 durch die Eingänge 44 und 46 abgefragt wird.

Der ohmsche Widerstand 40 hat dabei einen verhältnismäßig niedrigen Wert, der Wert muß gerade ausreichend sein, um überhaupt noch einen meßbaren Spannungsabfall zu erzeugen. Werte in der Größenordnung von 0,1 bis 0,01 Ohm sind dabei durchaus hinreichend. Dadurch lassen sich die durch den ohmschen Widerstand 40 verursachten Verluste einschränken.

Zum Zeitpunkt $t_0$ ist der Wert bis auf einen Schwellwert $I_{max}$ angestiegen. Das Steuergerät kann dabei zeitgesteuert arbeiten, d.h., es schaltet

zum Zeitpunkt $t_0$ ab, es kann auch mit Strommessung arbeiten, d.h., es schaltet bei Erreichen des Schwellwertes $I_{max}$ ab. Zum Zeitpunkt $t_0$ bzw. bei Erreichen des Stromes $I_{max}$ ist ein sicheres Fangen des Ankers gewährleistet, das Steuergerät kann nunmehr abschalten.

Dazu ist es notwendig, daß der Stromverlauf vom Pluspol 14 zum Masseanschluß 16 unterbrochen wird, dies muß dadurch geschehen, daß der Thyristor 30 wieder gelöscht wird. Allein durch einfache Beschaltung eines kostengünstigen Thyristors 30 jedoch ist ein Löschen nicht möglich, es muß kurzzeitig der durch den Thyristor 30 fließende Strom abgeschaltet werden, da sich der Thyristor 30 erst bei stromlosem Zustand wieder löscht.

Zu diesem Zwecke ist der Transistor 22 vorgesehen, dessen Basis 24 über den Ausgang 50 des Schaltgliedes 42 angesteuert wird, so daß die Strecke vom Kollektor 26 zum Emitter 28 durchschaltet und dementsprechend der Strom über den Transistor 22 fließt. Da der Widerstand des Transistors 22 im geöffneten Zustand geringer als der Widerstand des Thyristors 30 mit einem in Serie geschalteten ohmschen Widerstand 54, fließt der Strom im wesentlichen über den Transistor 22 und der Thyristor 30 löscht. Sofort danach kann der Transistor 22 durch entsprechende Wegnahme des Ansteuersignals an der Basis 24 gesperrt werden, ein weiterer Stromfluß vom positiven Anschluß 14 zum Masseanschluß 16 ist nicht mehr möglich.

Die Schaltung ließe sich selbstverständlich auch aufbauen, indem der Thyristor 30 weggelassen wurde und lediglich ein Transistor 22 den Stromfluß vom elektromagnetischen Verbraucher 10 mit Freilauf 12 zum Masseanschluß 16 steuert. Dazu jedoch muß ein verhältnismäßig großer Leistungstransistor 22 vorgesehen werden, da Ströme in Größenordnung bis zu 30 bis 50 Ampere zu steuern sind. Derartige Leistungstransistoren sind verhältnismäßig voluminös und zudem für den Serieneinsatz außerordentlich teuer.

Die Erfindung macht sich die Tatsache zunutze, daß ein Thyristor ein verhältnismäßig preiswertes Bauteil ist und dennoch zum Steuern, vor allem zum Einschalten großer Ströme und Spannungen geeignet ist. Der Transistor 22, wie er jetzt vorgesehen ist, muß nur sehr kurzzeitig den vollen Strom übernehmen, und eine kurzzeitige Spitzenbelastung eines Transistor kann die maximal zulässige Dauerbelastung um ein Vielfaches übersteigen, ohne daß der Transistor dabei Schaden nimmt.

Da der Schaltstoß des Transistors 22 nur solange andauern muß, bis der Thyristor 30 wieder gelöscht ist, kann der Transistor 22 für die maximalen Stromstärken deutlich unterdimensioniert werden, es reicht, wenn der Transistor 22 auf sehr viele niedrigere Dauerstromwerte eingerichtet ist.

Mit dem Unterbrechen des Stromes bricht der Stromfluß durch die Spule nicht schlagartig zusammen, über den Freilauf 12 fällt der Strom vielmehr allmählich ab, wie in Fig. 2 in dem Zeitraum zwischen $t_0$ und $t_{11}$ dargestellt.

Es ist natürlich möglich, diesen Stromdurchfluß durch die Spule 10 durch ein geeignetes Meßinstrument zu erfassen und dementsprechend, wenn ein unterer Schwellwert erreicht ist, den Strom wieder einzuschalten, damit in der Haltephase des Ankers des Gaswechselventiles sichergestellt ist, daß der Anker am Kern des Elektromagneten 10 kleben bleibt. Dies ist jedoch verhältnismäßig aufwendig, da man sich bei der Stromdurchflußabfrage durch die Spule Störspannungen einfängt, die das Meßergebnis unsicher machen. Außerdem gehen die Schwankungen der Versorgungsspannung als Meßfehler mit ein.

Ein Kernpunkt der Erfindung ist es, daß die Stromabfrage nicht im elektromagnetischen Verbraucher 10 stattfindet, bzw. in dem Stromkreis, der durch den elektromagnetischen Verbraucher 10 fließt, sondern durch den ohmschen Widerstand 40, der auf seiner einen Seite direkt am Masseanschluß 16 liegt und dementsprechend störungsanfällig ist.

Da jedoch dieser ohmsche Widerstand 40 den abfallenden Strom nicht erfaßt, wird der Stromabfall, dessen Abfallcharakteristik aufgrund der Betriebsparameter bekannt ist, im Steuergerät 42 simuliert. Die dadurch erzielte Genauigkeit ist ausreichend, um ein sicheres Betreiben der Schaltung und des elektromagnetischen Verbrauchers 10 zu gewährleisten.

Hat nun der simulierte Stromabfall einen unteren Wert $I_2$ erreicht, was in Fig. 2 zum Zeitpunkt $t_{11}$ dargestellt ist, wird der Stromdurchfluß durch den Magneten 10 wieder eingeschaltet. Dies kann entweder dadurch geschehen, daß der Transistor 22 durch Ansteuerung der Basis 24 über das Steuergerät 42 öffnet und somit der Strom vom Pluspol 14 zum Masseanschluß 16 fließen kann. Damit steigt der Strom wieder an bis zu einem Zeitpunkt $t_{12}$, dort erreicht er den Schwellwert $I_1$, der im Steuergerät 42 vorgegeben ist, der Transistor 22 wird gesperrt, und der Strom fällt wieder simuliert ab bis auf seinen unteren Schwellwert $I_2$, den er zum Zeitpunkt $t_{21}$ erreicht. Der Strom wird wieder eingeschaltet, erreicht seinen oberen Wert $I_1$ zum Zeitpunkt $t_{22}$, anschließend sperrt der Transistor 22 erneut, und die Abfallphase wird wiederum simuliert.

Auf diese Weise findet eine getaktete Stromversorgung des Elektomagneten 10 statt, wobei die Ströme verhältnismäßig niedrig gewählt, um Energie einzusparen. Durch die Freilaufbeschaltung ist auch lediglich ein Energiestoß zwischen dem Ein- und Ausschalten notwendig, die anschließende Abfallphase des Stromes geschieht über den Freilauf 12 und erfordert keine externe Stromzufuhr.

Die Stromwerte $I_1$ und $I_2$, zwischen denen sich der durch die Schaltung fließende Strom in der Haltephase, die sich der Fangphase anschließt, bewegt, beträgt größenordnungsmäßig etwa 10 bis 20% des Maximalstromes $I_{max}$, der während der Fangphase aufgewendet werden muß.

Dementsprechend ist es ohne weiteres möglich, diese deutlich geringeren Ströme in der Größenordnung von 3 bis 5 Ampere über den Transistor 22 zu steuern.

Alternativ dazu ist es selbstverständlich möglich, auch diesen Stromdurchfluß durch das Zünden des Thyristors 30 durch ein entsprechendes Signal am Ausgang 48 des Schaltgerätes 42 auf das Gate 36 zu ermöglichen, der Transistor 22 dient in diesem Falle ähnlich wie beim Abschalten des Fangstromes nur dazu, den Thyristor jeweils bei Erreichen eines Stromdurchflusses in der Größenordnung $I_1$ wieder zu löschen.

Der Einschaltzeitpunkt, der in Fig. 2 auf den Nullpunkt des Koordinatensystems gelegt wurde, wird über die Busleitung 52 dem Steuergerät 42 zugeführt. Ebenso erhält das Steuergerät 42 über die Busleitung 52 die Information des Abschaltens, wobei der Abschaltvorgang nicht Gegenstand dieser Erfindung ist. Wie in der DE-OS 2 828 678 offenbart, ist dabei ein Unterbrechen des Freilaufes 12 notwendig, um ein schlagartiges Abschalten zu erzielen, da durch den Freilauf 12 sonst selbst bei Sperren der Stromzufuhr ein Abfall des Stromdurchflusses mit der üblichen Abfallrate stattfinden würde.

Die übrigen Parameter, insbesondere die Schwellwerte $I_{max}$, $I_1$ und $I_2$ müssen dem Steuergerät 42 nicht zugeführt werden, diese Werte können im Steuergerät 42 selbst vorgegeben sein. Alternativ ist jedoch auch eine Festlegung dieser Schwellwerte abhängig von anderen Betriebsparametern über die Busleitung 52 möglich.

Ebenso ist die Abfallrate, die zur Simulation des abfallenden Stromverlaufes dient, im Steuergerät 42 selbt verankert.

Werden bei einem Mehrzylindermotor mehrere Gaswechselventile mit der erfindungsgemäßen Schaltung betrieben, ist diese Schaltung besonders vorteilhaft insofern, als sämtliche ohmschen Widerstände 40 an einem gemeinsamen Massepunkt 16 angeschlossen werden können, so daß Störeinflüsse, die in das Steuergerät 42 Eingang finden, möglichst gering gehalten werden. Auch Schaltungstoleranzen, die sich bei dem Aufbau identischer Schaltungen aufgrund der Streuungen in den Werten der Bauelemente ergeben, werden auf diese Weise optimal unterdrückt.

## Patentansprüche

Verfahren zum Betreiben eines Ventiles einer Brennkraftmaschine, mit einem die Bewegung des Ventiles beeinflussenden Elektromagneten, wobei der Elektromagnet eine Freilaufschaltung aufweist, in den Haltephasen der Elektromagnet des Ventils getaktet mit Strom versorgt wird, im Taktzyklus während der Stromzufuhr der Strom gemessen und bei Überschreiten eines Grenzwertes abgeschaltet wird, während in den Abschaltphasen der Strom nicht gemessen, sondern der Einschaltzeitpunkt anderweitig ermittelt wird, dadurch gekennzeichnet, daß beim Betrieb eines Gaswechselventils der Abfall der Kurve während der Abfallphase in einem Steuergerät unter Berücksichtigung der jeweiligen Betriebsparameter simuliert wird, und nach Erreichen eines unteren Schwellwertes ($I_2$) der simulierten Kurve der Strom wieder eingeschaltet wird.

## Claims

A method of operating a valve of an internal combustion engine, comprising an electromagnet which influences the valve movement and which includes a free wheeling circuit, the electromagnet of the valve being fed with clocked current supply during the holding phases, the current being measured at the clock cycle during the current supply and being disconnected as a limit value is exceeded, the current on the other hand not being measured during the disconnecting phases and the switch-on time instead being determined otherwise, characterized in that, during operation of a gas exchange valve, the dropping of the curve during the dropping phase is simulated in a control device in consideration of the respective operating parameters and the current is switched on again when a lower threshold value ($I_2$) of the simulated curve has been reached.

## Revendications

Procédé de commande d'une soupape d'un moteur à combustion interne, avec un électro-aimant qui influe sur le mouvement de la soupape, l'électro-aimant présentant un circuit à relaxation, l'électro-aimant de la soupape étant alimentée en courant de façon rythmée dans les phases de maintien, le courant étant mesuré dans le cycle rythmé ou d'horloge pendant l'alimentation de courant et étant coupé lors du dépassement d'une valeur limite, tandis que dans les phases de coupure, le courant n'est pas mesuré, mais l'instant de mise en circuit est déterminé autrement, caractérisé en ce que dans le cas de la commande d'une soupape à gaz à deux voies, la chute de la courbe pendant la phase de mise au repos est simulée dans un dispositif de commande en tendant compte des paramètres de fonctionnement particuliers et en ce qu'après qu'une valeur seuil inférieure ($I_2$) de la courbe simulée a été atteinte, le courant est rétabli.

FIG. 1

FIG. 2